# EUROPEAN PATENT APPLICATION

(11) **EP 4 813 570 A1**
(43) Date of publication of application: **30.09.2026**
(21) Application number: 26166553.3
(22) Date of filing: 20.03.2026
(51) Int. Cl.: B24B 37/30, B24B 37/10, B24B 37/34, B24B 53/017

(54) **CHEMICAL MECHANICAL PLANARIZATION (CMP) MACHINE WITH IMPROVED ARCHITECTURE**

(30) Priority: 24.03.2025 US 202563776786 P
(71) Applicant: ASM America, Inc., Phoenix, AZ 85034 (US)
(72) Inventor: TROJAN, Daniel Ray, Phoenix, 85034 (US); SHUGRUE, John Kevin, Phoenix, 85034 (US); ROOT, Franklin Dean, Phoenix, 85034 (US)
(74) Representative: V.O.

(57) **Abstract**

Chemical mechanical planarization (CMP) machines with improved architecture are provided. In one aspect, a chemical mechanical planarization apparatus includes a column, a first substrate carrier head system, and a second substrate carrier head system. Each of the first and second carrier head systems includes a polish arm connected to the column and a wafer carrier connected to the polish arm and configured to hold a substrate. The CMP apparatus also includes a platen configured to polish at least one of a first substrate held by the first carrier head system and a second substrate held by the second carrier head system. The column overlaps at least a portion of the platen.

## Description

### INCORPORATION BY REFERENCE TO ANY PRIORITY APPLICATIONS

Any and all applications for which a foreign or domestic priority claim is identified in the Application Data Sheet as filed with the present application are hereby incorporated by reference under 37 CFR 1.57. This application claims the benefit of the earlier filing date of U.S. provisional application No. 63/776,786 filed March 24, 2025, which is hereby incorporated by reference in its entirety under 37 CFR 1.57.

### BACKGROUND

### Field

The disclosed technology relates to semiconductor processing equipment, and more specifically, a chemical mechanical planarization (CMP) system and apparatus with a reduced footprint and operational capabilities that allow for handling and manipulation of objects in a condensed space.

### Description of the Related Technology

CMP machines are widely used in the semiconductor manufacturing industry.

There exists a need for a machine with substantially different architecture to enable solutions to certain needs in today's market. The types of machines available today have reduced throughput due to limited wafer handling and multi-wafer processing options.

### SUMMARY OF CERTAIN INVENTIVE ASPECTS

An objective of the disclosed technology is to provide an improved chemical mechanical planarization (CMP) apparatus with a reduced footprint and increased throughput and functionality.

In one aspect, a chemical mechanical planarization (CMP) apparatus is provided. The CMP apparatus includes a column, a first substrate carrier head system, and a second substrate carrier head system. Each of the first and second substrate carrier head systems includes a polish arm connected to the column and a wafer carrier connected to the polish arm and configured to hold a substrate. The CMP apparatus further includes a platen configured to polish at least one of a first substrate held by the first substrate carrier head system and a second substrate held by the second substrate carrier head system, wherein the column overlaps at least a portion of the platen.

In some embodiments, the CMP apparatus further includes a column support arranged above the platen, wherein the column support is configured to support the column and the first and second substrate carrier head systems.

In some embodiments, the platen is configured to simultaneously polish the first substrate and the second substrate on different areas of the platen. In some embodiments, the column substantially completely overlaps the platen.

In some embodiments, the CMP apparatus further includes a pad conditioner configured to sweep across substantially the entire platen during simultaneous polishing of the first and second substrates.

In some embodiments, the CMP apparatus further includes a first arc sweep pad conditioner configured to sweep across a portion of the platen upstream of the first substrate carrier head system and a second arc sweep pad conditioner configured to sweep across a portion of the platen upstream of the second substrate carrier head system during simultaneous polishing of the first and second substrates.

In some embodiments, the CMP apparatus further includes a plurality of transfer stations configured to hold substrates before and after polishing of the substrates. In some embodiments, the CMP apparatus further includes a central wafer handling robot configured to load and unload the substrates to and from the transfer stations.

In some embodiments, the CMP apparatus further includes a plurality of wafer handling robots configured to load and unload the substrates to and from the transfer stations.

In another aspect, a chemical mechanical planarization apparatus is provided that includes a column support, a first column and a second column, the first and second columns structurally supported by the column support, a first substrate carrier head system and a second substrate carrier head system, the first and second substrate carrier head systems structurally supported by the first column, and a third substrate carrier head system and a fourth substrate carrier head system, the third and fourth substrate carrier head systems structurally supported by the second column. The apparatus further includes a first platen configured to polish at least one of a first substrate held by the first substrate carrier head system and a second substrate held by the second substrate carrier head system, and a second platen configured to polish at least one of a third substrate held by the third substrate carrier head system and a fourth substrate held by the fourth substrate carrier head system, wherein the first column overlaps at least a portion of the first platen and the second column overlaps at least a portion of the second platen.

In some embodiments, the first platen is configured to simultaneously polish the first substrate and the second substrate on different areas of the first platen, and the second platen is configured to simultaneously polish the third substrate and the fourth substrate on different areas of the second platen.

In some embodiments, the apparatus further includes a third platen configured to polish the second substrate and a fourth platen configured to polish the fourth substrate, wherein the first column overlaps at least a portion of the first platen and a portion of the third platen, and the second column overlaps at least a portion of the second platen and a portion of the fourth platen.

In some embodiments, the first substrate carrier head system includes a polish arm connected to the first column and a wafer carrier connected to the polish arm and configured to hold the first substrate.

In some embodiments, the column support is arranged above the platen. In some embodiments, the first column is located above a plane of the first platen and the second column is located above a plane of the second platen. In some embodiments, the apparatus further includes a plurality of transfer stations configured to hold the substrates before and after polishing of the substrates, and a central wafer handling robot configured to load and unload the substrates to and from the transfer stations.

In another aspect, an inverted column assembly for a chemical mechanical planarization apparatus is provided. The inverted column assembly includes a column support and a first column and a second column, the first and second columns structurally supported by the column support. Each of the first and second columns is configured to support one or more substrate carrier head systems, wherein the first and second columns are located above a plane of one or more platens of the chemical mechanical planarization apparatus.

In some embodiments, the column support is secured to a ceiling. In some embodiments, the column support is secured to a support structure located above the chemical mechanical planarization apparatus.

In some embodiments, the first column overlaps at least a portion of a first platen of the one or more platens and the second column overlaps at least a portion of a second platen of the one or more platens.

In another aspect, a chemical mechanical planarization apparatus is provided, the chemical mechanical planarization apparatus including: a column; a first substrate carrier head system and a second substrate carrier head system, each of the first substrate carrier head system and the second substrate carrier head system including (i) a polish arm connected to the column and (ii) a wafer carrier connected to the polish arm and configured to hold a substrate; and a platen configured to polish at least one of a first substrate held by the first substrate carrier head system and a second substrate held by the second substrate carrier head system, the column overlapping at least a portion of the platen.

In some embodiments, the chemical mechanical planarization apparatus further includes a column support arranged above the platen, the column support configured to support the column, the first substrate carrier head system, and the second substrate carrier head system.

In some embodiments, the column is located above a plane of the platen.

In some embodiments, the platen is configured to simultaneously polish the first substrate and the second substrate on different areas of the platen.

In some embodiments, the column substantially completely overlaps the platen.

In some embodiments, the chemical mechanical planarization apparatus further includes a pad conditioner configured to sweep across substantially the entire platen during the simultaneous polishing of the first substrate and the second substrate.

In some embodiments, the chemical mechanical planarization apparatus further includes a first arc sweep pad conditioner configured to sweep across a portion of the platen upstream of the first substrate carrier head system during the simultaneous polishing of the first substrate and the second substrate, and a second arc sweep pad conditioner configured to sweep across a portion of the platen upstream of the second substrate carrier head system during the simultaneous polishing of the first substrate and the second substrate.

In some embodiments, the chemical mechanical planarization apparatus further includes a plurality of transfer stations configured to hold substrates before and after polishing of the substrates.

In some embodiments, the chemical mechanical planarization apparatus further includes a central wafer handling robot configured to load and unload the substrates to and from the plurality of transfer stations.

In some embodiments, the chemical mechanical planarization apparatus further includes a plurality of wafer handling robots configured to load and unload the substrates to and from the plurality of transfer stations.

In some embodiments, the column is rotatably coupled to the column support such that the column is configured to rotate about a substantially vertical axis relative to the column support.

In some embodiments, the chemical mechanical planarization apparatus further includes a motor configured to drive rotation of the column, at least one bearing supporting the column during the rotation, and a sensor configured to provide rotational position feedback to a controller.

In some embodiments, the column support includes one or more internal routing passages, raceways, or channels configured to route one or more of electrical power, control signals, data communications, pneumatic pressure, vacuum, coolant, or process fluids between an overhead utility source and the column.

In some embodiments, the chemical mechanical planarization apparatus further includes one or more rotary couplings configured to maintain connectivity of the one or more of electrical power, control signals, data communications, pneumatic pressure, vacuum, coolant, or process fluids during rotation of the column relative to the column support.

In another aspect, a chemical mechanical planarization apparatus is provided, the chemical mechanical planarization apparatus including: a column support; a first column and a second column, the first column and the second column structurally supported by the column support; a first substrate carrier head system and a second substrate carrier head system, the first substrate carrier head system and the second substrate carrier head system structurally supported by the first column; a third substrate carrier head system and a fourth substrate carrier head system, the third substrate carrier head system and the fourth substrate carrier head system structurally supported by the second column; a first platen configured to polish at least one of a first substrate held by the first substrate carrier head system and a second substrate held by the second substrate carrier head system; and a second platen configured to polish at least one of a third substrate held by the third substrate carrier head system and a fourth substrate held by the fourth substrate carrier head system, the first column overlapping at least a portion of the first platen and the second column overlapping at least a portion of the second platen.

In some embodiments, the first platen is configured to simultaneously polish the first substrate and the second substrate on different areas of the first platen, and the second platen is configured to simultaneously polish the third substrate and the fourth substrate on different areas of the second platen.

In some embodiments, the chemical mechanical planarization apparatus further includes a pad conditioner for each of the first platen and the second platen, each pad conditioner configured to sweep across substantially an entire diameter of the corresponding platen during the simultaneous polishing.

In some embodiments, the chemical mechanical planarization apparatus further includes, for each of the first platen and the second platen, a first arc sweep pad conditioner configured to sweep across a portion of the corresponding platen upstream of a first wafer carrier and a second arc sweep pad conditioner configured to sweep across a portion of the corresponding platen upstream of a second wafer carrier during the simultaneous polishing.

In some embodiments, the column support is arranged above the first platen and the second platen, and the first column is located above a plane of the first platen and the second column is located above a plane of the second platen.

In some embodiments, the column support includes an overhead frame or gantry configured to support a plurality of columns and to distribute one or more utilities to the plurality of columns via one or more shared utility manifolds, distribution blocks, or routing channels.

In another aspect, an inverted column assembly for a chemical mechanical planarization apparatus is provided, the inverted column assembly for a chemical mechanical planarization apparatus including: a column support; and a first column and a second column, the first column and the second column structurally supported by the column support, each of the first column and the second column configured to support one or more substrate carrier head systems, the first column and the second column located above a plane of one or more platens of the chemical mechanical planarization apparatus.

In some embodiments, the column support is secured to a ceiling.

In some embodiments, the column support is secured to a support structure located above the chemical mechanical planarization apparatus.

In some embodiments, the first column overlaps at least a portion of a first platen of the one or more platens and the second column overlaps at least a portion of a second platen of the one or more platens.

In some embodiments, the column support includes one or more internal routing passages, raceways, or channels configured to route one or more of electrical power, control signals, data communications, pneumatic pressure, vacuum, coolant, or process fluids to at least one of the first column or the second column.

In some embodiments, the inverted column assembly for a chemical mechanical planarization apparatus further includes vibration isolation between a facility structure and the column support and/or between the column support and at least one of the first column or the second column.

In another aspect, a chemical mechanical planarization apparatus is provided, the chemical mechanical planarization apparatus including: a column support arranged above one or more platens; a column structurally supported by the column support; two or more substrate carrier head systems structurally supported by the column, each substrate carrier head system including (i) a polish arm connected to the column and (ii) a wafer carrier connected to the polish arm and configured to hold a substrate; and the one or more platens configured to polish one or more substrates held by the two or more substrate carrier head systems, the column overlapping at least a portion of at least one platen of the one or more platens.

In some embodiments, the column is located above a plane of the at least one platen.

In some embodiments, the one or more platens include a platen configured to simultaneously polish a first substrate held by a first substrate carrier head system of the two or more substrate carrier head systems and a second substrate held by a second substrate carrier head system of the two or more substrate carrier head systems on different areas of the platen.

In some embodiments, the chemical mechanical planarization apparatus further includes a pad conditioner configured to condition a polishing pad on the platen in a single-substrate polishing mode and in a dual-substrate polishing mode.

In some embodiments, the pad conditioner is configured to sweep across substantially the entire platen.

In some embodiments, the chemical mechanical planarization apparatus further includes a first arc sweep pad conditioner configured to sweep across a portion of the platen upstream of the first substrate carrier head system and a second arc sweep pad conditioner configured to sweep across a portion of the platen upstream of the second substrate carrier head system.

In another aspect, a chemical mechanical planarization apparatus is provided, the chemical mechanical planarization apparatus including: a column support; a first column and a second column, the first column and the second column structurally supported by the column support; a first substrate carrier head system and a second substrate carrier head system, the first substrate carrier head system and the second substrate carrier head system structurally supported by the first column, each of the first substrate carrier head system and the second substrate carrier head system including (i) a polish arm connected to the first column and (ii) a wafer carrier connected to the polish arm and configured to hold a substrate; a third substrate carrier head system and a fourth substrate carrier head system, the third substrate carrier head system and the fourth substrate carrier head system structurally supported by the second column, each of the third substrate carrier head system and the fourth substrate carrier head system including (i) a polish arm connected to the second column and (ii) a wafer carrier connected to the polish arm and configured to hold a substrate; a first platen configured to polish at least one of a first substrate held by the first substrate carrier head system and a second substrate held by the second substrate carrier head system; a second platen configured to polish at least one of a third substrate held by the third substrate carrier head system and a fourth substrate held by the fourth substrate carrier head system; and a third platen and a fourth platen, the first column overlapping at least a portion of at least one of the first platen or the third platen, and the second column overlapping at least a portion of at least one of the second platen or the fourth platen.

In some embodiments, the column support is arranged above the first platen, the second platen, the third platen, and the fourth platen.

In some embodiments, the first column is located above a plane of the first platen and above a plane of the third platen, and the second column is located above a plane of the second platen and above a plane of the fourth platen.

In some embodiments, the chemical mechanical planarization apparatus further includes a plurality of transfer stations configured to hold substrates before and after polishing of the substrates, and a central wafer handling robot configured to load and unload the substrates to and from the plurality of transfer stations.

In some embodiments, at least one of the first platen or the second platen is configured to simultaneously polish two substrates on different areas of the platen.

In some embodiments, the column support includes an overhead frame or gantry configured to support a plurality of columns and to distribute one or more utilities to the plurality of columns via one or more shared utility manifolds, distribution blocks, or routing channels.

### BRIEF DESCRIPTION OF THE DRAWINGS

The above, as well as additional objects, features and advantages of the disclosed technology, will be better understood through the following illustrative and non-limiting detailed description of embodiments of the disclosed technology, with reference to the appended drawings. In the drawings, like reference numerals will be used for like elements unless stated otherwise.
FIG. 1A is a plan view of a chemical mechanical planarization (CMP) system, according to embodiments of the disclosed technology.
FIG. 1B is a side view of a CMP system, according to embodiments of the disclosed technology.
FIG. 2 is a cross-sectional view of an example carrier head assembly of a CMP system.
FIG. 3A and FIG. 3B are plan views of a CMP apparatus including links, according to embodiments of the disclosed technology.
FIG. 4 is a plan view of a CMP system including a platen, according to embodiments of the disclosed technology.
FIG. 5 is an isometric view of an example CMP system, according to embodiments of the disclosed technology.
FIG. 6 is a flowchart illustrating an example method for operating a CMP system, according to embodiments of the disclosed technology.
FIG. 7 illustrates an embodiment of a CMP system having an inverted column assembly in accordance with aspects of this disclosure.
FIG. 8A and FIG. 8B illustrate embodiments of CMP systems having an inverted column assembly in accordance with aspects of this disclosure.
FIG. 9 provides a side view of a CMP system having an inverted column assembly in accordance with aspects of this disclosure.

### DETAILED DESCRIPTION

The disclosed technology relates to a CMP machine with a reduced footprint over that of a typical CMP machine and has operational capabilities that allow the machine to handle and manipulate wafer objects in a condensed space. The disclosed technology is also related to a CMP machine with articulable arms with elbow joints and shoulders connected to a support. The disclosed technology is also related to a CMP machine with the operational capabilities to polish two or more wafers on a single polishing platen as part of a staggered process such that the critical period of time for polishing a wafer is not interrupted or disrupted by the polishing of subsequent wafers. The disclosed technology is also related to improved offline consumables preparation by providing a system where platen pads may be efficiently removed and replaced with pre-conditioned platen pads without causing down time of the machine as it relates to utilizing other platens within the system.

There exists a need for a machine with substantially different architecture to enable solutions to certain needs in today's market. The types of machines available today, and their respective shortcomings, include machines which have reduced throughput due to having to perform wafer handling and loading/unloading sequentially with processing steps, machines which can process only a single wafer per platen, machines which require wafer carrier(s) (also referred to as a carrier head or wafer carrier head, or substrate carrier head system) to move concurrently between polishing platens with all other heads due to being fixably coupled to one another, machines where one platen cannot be utilized while wafer carrier(s) are waiting for process and/or wafer loading/unloading operations to be completed on other heads and/or platens, and machines which require transferring a wafer from one wafer carrier to another in order to process the wafer between multiple platens.

The disclosed technology will be described with respect to particular embodiments and with reference to certain drawings. The disclosure is not limited thereto but only by the claims. The drawings described are only schematic and are non-limiting. In the drawings, the size of some of the elements may be exaggerated and not drawn to scale for illustrative purposes. The dimensions and the relative dimensions do not necessarily correspond to actual reductions to practice of the disclosure.

The adoption and use of chemical mechanical polishing (CMP) for the planarization of thin films in the manufacture of semiconductor ICs, MEMS devices, and LEDs, among many other similar applications is common among all companies manufacturing "chips" for these types of devices. This adoption includes the manufacture of chips for mobile telephones, tablets and other portable devices, plus desktop and laptop computers. The growth in nanotechnology and micro-machining holds great promise for ever-widespread use and adaptation of digital devices in the medical field, in the automotive field, and in the Internet of Things (the "IoT"). Chemical mechanical polishing for the planarization of thin films was invented and developed in the early 1980s by scientists and engineers at the IBM Corporation. Today, this process is widespread on a global basis and is one of the truly enabling technologies in the manufacture of nearly all digital devices.

Integrated circuits are manufactured with multiple layers and alternating layers of conducting materials (copper, tungsten, aluminum, etc.), insulating layers (silicon dioxide, silicon nitride, etc.), and semiconducting material (polysilicon). A successive combination of these layers is sequentially applied to the wafer surface, but because of the implanted devices on the surface, topographical undulations are built up upon the device structures, as is the case with silicon dioxide insulator layers. These unwanted topographical undulations must be flattened or "planarized" before the next layer can be deposited. In the case of copper layers, the copper is deposited on the surface to fill contact vias and make effective vertical paths for the transfer of electrons from device to device and from layer to layer. This procedure continues with each layer that is applied (usually applied by a deposition process). In the case of multiple layers of conducting material (multiple layers of metal), this could result in numerous polishing procedures (one for each layer of conductor, insulator, and semiconductor material) in order to achieve successful circuitry.

The CMP process is an enabling technology in the manufacture of multi-layer circuitry that makes this all possible.

Detailed embodiments of the disclosed technology will now be described with reference to the drawings.

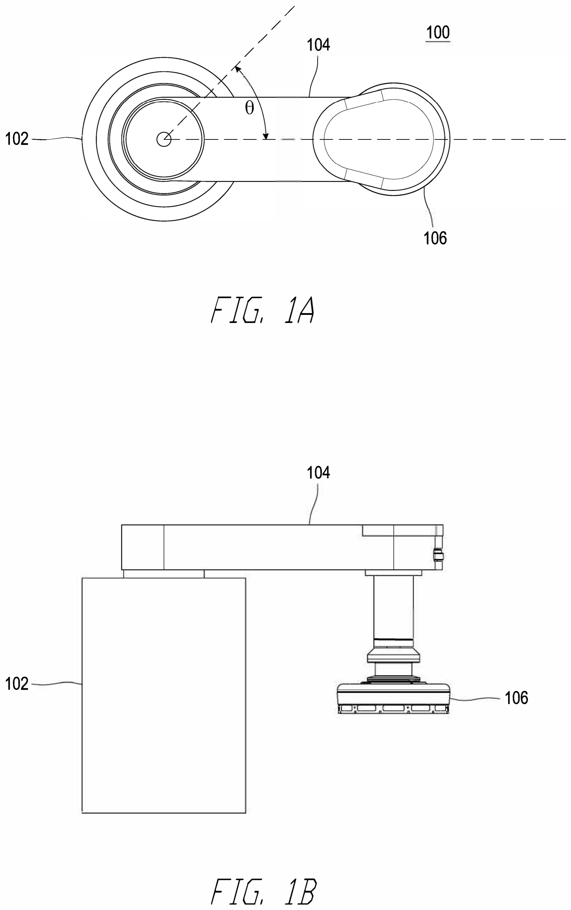

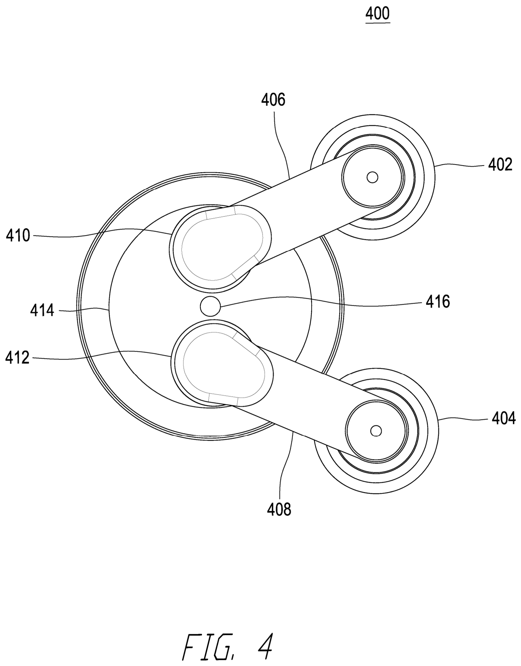

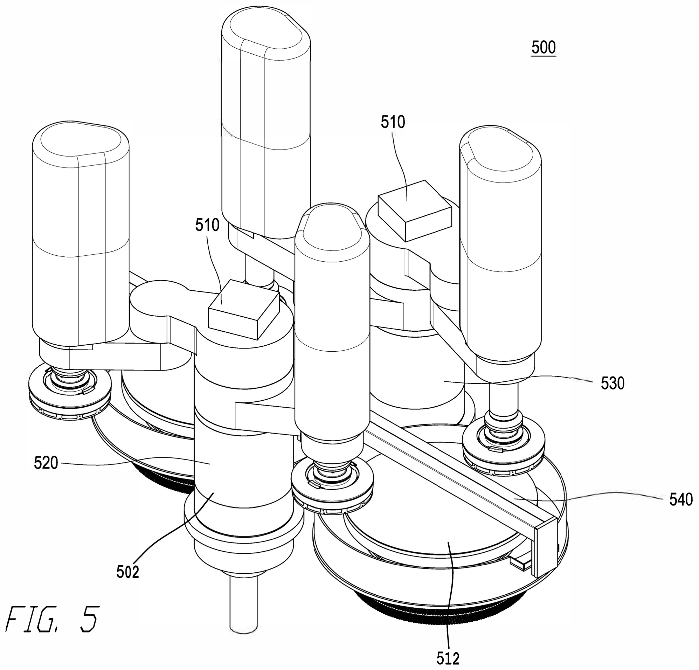

FIG. 1A is a plan view illustrating an embodiment of a chemical mechanical planarization (CMP) system 100 including a support 102 (e.g., body, column, base, polish arm support, etc.), an arm 104 (e.g., elongated member or polish arm), and a carrier head 106. The arm 104 attaches to support 102 and has a carrier head 106 attached. CMP system 100 may also include a means for rotating the arm attachments (not shown) as further discussed below. The support 102 is a structural support that is configured to hold the arm 104 and carrier head 106 in place above one or more polishing platens (shown in FIG. 4 and FIG. 5). In addition, the support 102 is configured to rotate the arm 104 that is rotatably attached to support 102. In some embodiments, the support 102 or portions thereof may rotate such that arm 104 attached to support 102 rotates about support 102. Alternatively, support 102 may be configured to be stationary while arm 104 attached to support 102 rotates about support 102. FIG. 1B is a side view of CMP system 100.

In some embodiments, support 102 is configured to provide electrical and fluid connections to the rest of the CMP system 100. Accordingly, support 102 has electrical/electromechanical connections and fluid connections disposed within support 102 and/or along the outer periphery of support 102. The electrical connections are configured to transmit power and electrical signals to one or more components of the CMP system 100 and receive electrical signals as feedback from the CMP system 100. For example, CMP system 100 may have wiring, such as Ethernet connections and electrical slip ring assemblies that can be fed through the bottom of support 102 and up to various components of the CMP system 100. In addition, fluid connections can be included, and configured to provide various fluids to the CMP system 100 (e.g., CMP slurry). The fluid connections can provide pneumatic pressure and vacuum force to the system.

In an embodiment, the CMP system 100 can be configured to rotate about an axis of rotation. Accordingly, support 102 includes means for rotating arm 104 about an axis of rotation. Support 102 may include, for example, an electric motor (e.g., stepper motor, brushless motor, torque motor, etc.), mechanical gears, magnetic or rotational couplings or any other means for producing rotational motion on the arm 104 or support 102.

In the example of FIG. 1A, the axis of rotation passes through support 102. The degree of rotation is indicated by the θ symbol in FIG. 1A. The direction of rotation, however, may be in either direction (clockwise or counterclockwise). In addition, the arm 104 and carrier head 106 may rotate about the axis of rotation (i.e., wind or unwind) at least about 270° in a single direction (i.e., angular displacement of ≥ 270°). In another embodiment, the rotation of arm 104 about the axis of rotation may be continuous (i.e., unrestricted), and thus, CMP system 100 can have an angular displacement of 360° or more (i.e., ≥ 2π radians).

In addition, the carrier head 106 attached to the arm can actuate in a downward (i.e., lowered) and upward (i.e., raised) direction. Accordingly, carrier head 106 can lower or raise based on the desired configuration for CMP processing. For example, in a raised configuration, carrier head 106 or arm 104 may receive a control signal commanding carrier head 106 to lower. Carrier head 106 may lower until it presses against a polishing pad of a platen (not shown). For example, carrier head 106 may press a wafer held beneath the undercarriage of carrier head 106 against the polishing pad.

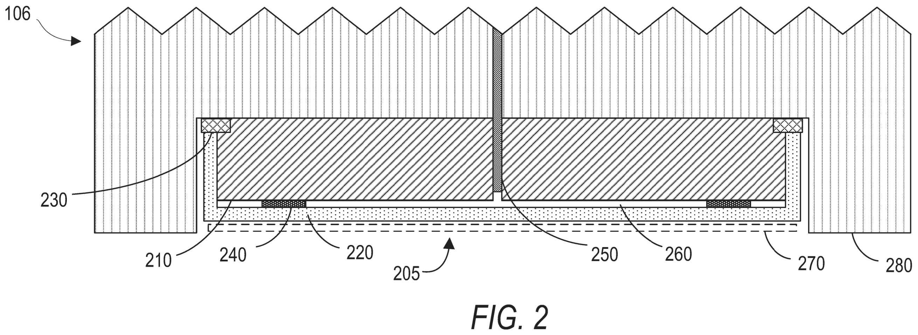

FIG. 2 is a cross-sectional view of carrier head 106. Carrier head 106 can include a membrane assembly 205 and a support base 280 to which the membrane assembly 205 is mounted. The support base 280 can be any suitable configuration configured to provide support to the membrane assembly. The support base 280 can attach and interface the remainder of the carrier head 106 with CMP system 100.

The membrane assembly 205 may include a support plate 210, a resilient membrane 220, a membrane clamp 230, and an outer pressure ring 240, as shown. The support plate 210 can be any suitable configuration to attach membrane assembly 205 to support base 280. For example, the support plate 210 may be mounted to the support base 280 using one or more bolts or other suitable attachment elements. The support plate 210 may be mounted to the support base 280 at various locations, such as along the outer perimeter of the support base 280.

The support plate 210 can be any suitable configuration to support the resilient membrane 220. The resilient membrane 220 may be secured to the support plate 210 in a number of different ways. The resilient membrane 220 may be secured to the support plate 210 before or after the support plate 210 is secured to the support base 280. The resilient membrane 220 may be secured to the support plate 210 through use of any of a number of suitable different holding elements, such as the membrane clamp 230. In some embodiments, the membrane clamp 230 may be spring loaded. In other embodiments, the membrane clamp 230 may tighten securely through the use of a fastening mechanism (e.g., nuts and bolts, etc.).

The resilient membrane 220 can be secured to the support plate 210 such that the membrane 220 can hold a wafer 270 against a polishing pad and process the wafer, for example, as described above with reference to FIG. 1B. The term "substrate" and "wafer" are used interchangeably herein, and include, for example, semiconductor or silicon wafers, flat panel displays, glass plates or disks, plastic work-pieces, and other substantially rigid, flat and thin work-pieces of various shapes (e.g., round, square rectangular, etc.) and sizes on which one or more embodiments of the apparatuses and processes disclosed herein can be implemented.

The membrane 220 can be sufficiently resilient and flexible, such that in combination with the polishing pad materials and process parameters, wafer breakage is reduced. The membrane 220 and support plate 210 can be configured to allow gas pressure between the membrane 220 and support plate 210, and press the membrane 220 against the wafer 270 during CMP processing. For example, a substantial seal can be formed between the membrane 220 and plate 210. The support plate 210 can be spaced from the membrane 220, to form a gap or cavity 260 therebetween. The cavity 260 can be formed when the membrane 220 is in a quiescent (e.g., non-pressurized) state. In some embodiments, the membrane 220 rests upon or proximate to the plate 210 when the membrane 220 is in a quiescent state, and the cavity 260 is formed when the membrane 220 is expanded (e.g., pressurized). The cavity 260 can redistribute and account for variations in the gas pressure against the membrane 220, and thus, against the wafer 270, during planarization. The gas pressure can be provided to the backside of the membrane 220 through a pneumatic channel 250, as shown. The pneumatic channel 250 may be disposed within the support plate 210, or can supply gas through other configurations. The pneumatic channel 250 may be modified differently depending on the application (e.g., a circular tube, a square tube, etc.). In some embodiments, the pneumatic channel may provide vacuum for retaining a wafer 270 to the underside of the membrane assembly. The membrane 220 may include holes, to either provide such vacuum, and/or allow for positive pressure to disengage the wafer 270 from the membrane 220.

In some embodiments, the cavity 260 can be formed by spacing the membrane 220 from the support plate 210. For example, the support plate 210 can include a recessed inner portion to form a cavity. In the illustrated embodiment, the membrane assembly 205 can include an outer pressure ring 240 to form the cavity 260. In other embodiments, the membrane assembly may be assembled without pressure rings. For example, the membrane 220 may rest directly against the support plate 210 without a cavity 260 separating the membrane 220 from the support plate 210. In some embodiments, the membrane assembly may include one or more pressure rings 240 arranged in concentric circles.

In another embodiment, the membrane 220 used may be a multi-zoned membrane. For example, the membrane 220 may have grooves (e.g., indentations) and/or raised portions of the membrane 220 that effectively segregate various zones of the membrane 220. In a non-limiting example, the grooves may be arranged in a series of concentric circles originating from the center of the membrane. In another example, the grooves and raise portions may be irregularly shaped (e.g., interconnecting circles, non-circular indentations, circular patterns scattered across the surface of the membrane) in order to improve distribution of pressure applied across the wafer 270 when attached to the membrane assembly.

The membrane 220 may be flexible such that it conforms to a structure that it surrounds. In some instances, the membrane 220 may be convex. For example, the membrane 220 may sag in the center. The membrane 220 may even be shaped like a cone such that a small area of the membrane 220 would be in contact with the wafer surface for finer precision polishing.

The membrane material may be any resilient material suitable for planarization, as described herein, and for use, for example, within a carrier head for a CMP process. In some embodiments, the membrane material may be one of rubber or a synthetic rubber material. The membrane material may also be one of Ethylene propylene diene monomer (M-class) (EPDM) rubber or silicone. Alternatively, it may be one or more combinations of vinyl, rubber, silicone rubber, synthetic rubber, nitrile, thermoplastic elastomer, fluoroelastomers, hydrated acrylonitrile butadiene rubber, or urethane and polyurethane formulas.

One or more membrane assemblies can be implemented within a single CMP system. The CMP system may have controls utilizing feedback from the system while operating to more accurately control the CMP process (e.g., variable speed motor controls, etc.).

In some embodiments, the arm or arms of the CMP system, described with reference to FIG. 1A, FIG. 1B and FIG. 2, can bend or rotate about a second axis of rotation such that the carrier head can tuck inward, toward the support and/or outward, away from the support. In some instances, the elongated arm may comprise multiple links that may all rotate about various axes of rotation (i.e., an articulating or jointed arm).

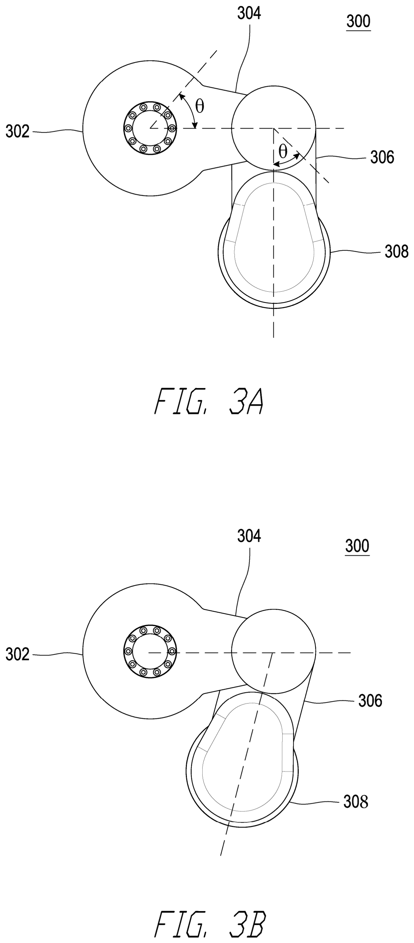

FIG. 3A and FIG. 3B illustrate plan views of a chemical mechanical planarization (CMP) system 300 embodiment including links 304 and 306. CMP system 300 is substantially similar to CMP system 100 described in FIG. 1A to FIG. 1B and FIG. 2. However, CMP system 300 is different in that the arm or arms can bend or rotate about a second axis of rotation such that carrier head 308 can tuck inward, toward the support, as shown in FIG. 3B, or outward, away from the support in the opposite direction, as shown in FIG. 3A. For example, CMP system 300 may include a first link 304 attached to the support 302, a second link 306 attached to the first link 304, and a carrier head 308 attached to the second link 306. In a non-limiting example, the links may be joined at a center joint (i.e., an elbow).

In some embodiments, first link 304 is rotatably attached to support 302 and defines a first axis of rotation that passes through support 302. In addition, first link 304 may be rotatably attached to second link 306 defining a second axis of rotation through the area of attachment between links. Alternatively, first link 304 may not be configured to rotate where only the second link 306 is configured to rotate about the second axis of rotation. The attachment section includes means for rotating the second link about the second axis of rotation, including similar features as described with reference to FIG. 1A to FIG. 1B. Electrical and fluid connections can likewise be included throughout the links as described with reference to FIG. 1A to FIG. 1B.

Accordingly, the links, including the first link 304 and/or the second link 306, may be configured to rotate about their respective axes of rotation (i.e., first axis of rotation, second axis of rotation, etc.). For example, second link 306 may be configured to rotate about the second axis of rotation that passes through the link attachment section. In some embodiments, the second link 306 may be configured to rotate about the second axis of rotation such that second link 306 extends outward to create a straight line with the other link and the first axis of rotation. In other embodiments, second link 306 may rotate between 0° to 180° and between 180° to 270° and between 270° and 360° about the second axis of rotation. For example, second link 306 may rotate about the second axis of rotation in a substantially unrestricted manner.

In some embodiments, the links may rotate independently of other links in the link chain and independent of support 302. In other embodiments, certain links may be coupled together such that their movement is dependent on another link's movement or the movement of support 302. For example, one or more links and support 302 may be coupled together by rotary gears or magnets such that when the support or another link rotates, the links or support that are coupled together also move.

Furthermore, the CMP system may comprise multiple supports with one or more arms attached to each support. For example, each support may have two arms. Furthermore, each arm may be comprised of links as discussed with reference to FIGS. 3A-3B. In addition, multiple platens may be configured in proximity to each support. For example, two platens may be located between two supports such that each carrier head of the two supports can access each platen for CMP processing. In another example, a single platen may be configured in proximity to two supports where each carrier head is configured to access the platen for processing, as shown in FIG. 4.

In some embodiments, wafers are presented to a prescribed load station (not shown) and prepared for loading onto carrier head 308. Wafer transfer from the Equipment Front End Module (EFEM) to the load/unload stations is accomplished via an overhead gantry robot mechanism, for example.

Carrier head 308 is positioned concentrically and overhead of loading/unloading station (not shown), and the wafer is transferred from the station to the carrier head 106. A person of ordinary skill in the art would understand the various methods and means for loading and unloading a wafer onto a carrier head.

Carrier head 308 is positioned as shown over a platen to perform the polishing process. While the polishing process proceeds, a next wafer can be placed onto loading/unloading station (not shown) for subsequent processing. Once the polishing process is completed, the links 304 and 306 supporting carrier head 308 and the elbow (i.e., joint) between links can articulate such that carrier head 308 "tucks in" toward support 302 (as shown by the progression from FIG. 3A to FIG. 3B), allowing rotation of the carrier about the support 302 within a smaller space envelope than would be possible if untucked instead. As such, this allows the positioning of carrier head 308 concentrically and overhead of the unloading station.

Carrier head 308 can then rotationally be positioned back to the position for transferring a subsequent wafer to carrier 308 from a load station, which can then be positioned for processing over a platen.

The processed wafer may then be unloaded onto an unloading station and retrieved by a transfer robot for return to the EFEM or, more commonly, to a cleaning system.

To increase system throughput, this same sequence can be applied to the corresponding set of components located symmetrically opposite a platen, such that carrier 308 is processing on a platen while wafers are being loaded onto or unloaded from a second carrier head using additional loading and unloading stations.

FIG. 4 illustrates an example embodiment of a CMP system 400, similar to CMP systems 300 and 100 previously described, including a platen 414 that is configured to process a substrate held by each of carrier heads 410 and 412. In some embodiments, arms 406 and 408 are substantially similar to arm 104. Alternatively, arms 406 and 408 may comprise links such as links 304 and 306 described with reference to FIG. 3A to FIG. 3B. In addition, carrier heads 410 and 412 may be substantially similar to carrier heads 106 or 308, and supports 404 and 402 may be substantially similar to supports 102 or 302. In an illustrative example, platen 414 can be configured in any number of shapes (e.g., circular, square, etc.) and as such, will have a center. In the example of FIG. 4, platen 414 is a circle having a center 416. Additionally, CMP system 400 can be configured with any number of platens where, for example, each platen or pair of adjacent platens have a number of corresponding supports.

In addition, each of the arms 406 and 408 can rotate about their respective axes of rotation that pass through each of the supports 402 and 404. Furthermore, each arm may be configured to rotate about their respective axes of rotation with an angular displacement of 270° or more. In some instances, arm 406 and/or 408 may be configured to rotate about their respective axes of rotation in a substantially unrestricted manner.

In some embodiments, CMP system 400 may include one or more stations for loading and/or unloading a wafer object to and from one or more carrier heads. For example, each carrier head may have a dedicated load station and/or unload station for loading wafers onto the carrier head or unloading a wafer from the carrier head. Two or more carrier heads may have a common load/unload station relative to each other, for processing on the same, or different platens. In addition, each station may be placed at approximately the same radial distance from each of supports 404 and 402. Alternatively, each station may be located at different radial distances from each of supports 404 and 402. Each station may be placed at the same or different radial distances from a support, relative to other station(s). Thus, in an embodiment where one or more arms of FIG. 4 comprises links, the arms may articulate to reach various configurations of the various stations, with greater flexibility in different configurations and locations of the various supports.

Accordingly, multiple wafers may be processed on a common platen. This may be desirable in certain applications to increase throughput relative to processing a single wafer on a single platen. In a non-limiting example, the two or more wafers may be loaded onto carrier heads 410 and 412. Loading may be done at a loading station (not shown). In addition, there may be an unloading station that in some examples has a separate configuration than the loading station. Both carrier heads 410 and 412 may be positioned over platen 414 (as shown), such that both wafers may be processed substantially concurrently. Once processing of both wafers is complete, carriers are positioned over suitable stations for unloading (not shown), then positioned over suitable loading stations (not shown) for loading additional wafers onto carriers 410 and 412 for subsequent processing. Alternatively, the carrier heads may alternate or stagger processing of their respective wafers. For example, carrier head 410 may process a first wafer on platen 414 for a specified amount of time or for a specific percentage of the overall process. Meanwhile, carrier head 412 may be configured in a raised position such that carrier head 412 does not press against platen 414 until it receives a control signal to lower its head and process the second wafer against platen 414. When carrier head 412 receives the control signal to lower its head, carrier head 410 can receive a control signal to raise its head such that the first wafer is no longer being processed. Alternatively, carrier head 410 may remain with its head down such that both carrier heads are processed concurrently.

In addition, the CMP systems described with respect to FIG. 1A to FIG. 1B, FIG. 2, FIG. 3, or FIG. 4 may be implemented in a number of different combinations, for example, as shown in FIG. 5. For example, FIG. 5 illustrates CMP apparatus 500 including a first CMP system 520 and a second CMP system 530. In this illustrated embodiment, each CMP system includes two arms comprising links and two platens. Accordingly, each platen is configured to process one or more wafers from each of the CMP systems.

In the example embodiment of FIG. 5, CMP systems 520 and 530 have two arms with links. Although the CMP systems 520 and 530 of FIG. 5 are shown with the arms comprising links, it is to be understood that the system can be configured with one or more of the arms having no links as described with reference to 1 and FIG. 4. In addition, CMP systems 520 and 530 can have any number of arms extending from their respective supports 502. Furthermore, CMP apparatus 500 can have any number of platens 512. In some embodiments, the two arms attached to a single support 502 can both rotate in the same direction as each other at substantially the same time about a common axis of rotation such that they change positions with one another.

In addition, CMP systems 520 and 530 may be equipped with a controller 510 as shown. Alternatively, the controller 510 may be located within the CMP system (e.g., within a support 502 of CMP system 520 and/or 530). In addition, controller 510 can be an electronic controller, mechanical, pneumatic or a combination. Additionally, any of the apparatus and systems described herein can include a controller (e.g., controller 510, FIG. 5) which can be configured to provide the functionality of the methods described herein, and additional functionality. In addition, any of the apparatus and systems described herein can include devices for tracking direction and angular displacement of the CMP carrier heads (e.g., an absolute encoder, etc.). In addition, any of the apparatus and systems described herein can include platens 512 with polishing pads that are configured to rotate or spin. Furthermore, any of the apparatus and systems described herein can include carrier heads that are configured to rotate or spin. For example, a carrier head holding a wafer may spin the wafer while processing the wafer against a spinning platen 512.

In addition, the wafer carriers described above, which attach to the outer portion of the outer links (or arms if there are no links), provide pressure to the wafer being processed. The wafer carrier heads can lower toward the platen 512 and rise up away from the platen 512 depending on the desired operation. Wafer carrier is also configured to support loading and unloading operations of wafers before and after CMP processing. The carrier head is also configured to move linearly (or radially if the platen 512 is a circle) in towards center of the platen 512 (as described above with respect to center 416) due to a synchronized rotational motion of both links. For example, the carrier head can press a wafer against an area of the platen 512. The controller may then command both links to rotate in a synchronized motion such that the wafer is moved toward the center of the platen 512. Furthermore, the carrier head is further configured to oscillate inward and outward along the line or radius.

Moreover, each platen 512 may include a pad conditioner system 540. The pad conditioner 540 can sweep across the entire polishing platen 512 or any portion thereof. A pad conditioner 540 can be configured to condition the pad before, during and/or after polishing a wafer. For example, the pad conditioner 540 can be configured to sweep across substantially the entire diameter of the platen 512.

In the embodiment of FIG. 5, the pad conditioner 540 includes an abrasive pad with an abrasive surface facing the platen 512. As shown in FIG. 5, pad conditioner 540 can form a track that is arranged across the platen 512 and the abrasive pad can travel along the track to sweep across the platen 512.

Advantageously, the pad conditioner 540 can be configured to sweep across the platen 512 during the simultaneous processing of the first and second substrates. This can reduce the differences in the surface conditions experienced by two substrates being processed. For example, in certain embodiments, by sweeping the pad conditioner 540 across substantially the entire platen 512, the pad conditioner 540 can alternate between being located upstream of the first substrate carrier head system and being located upstream of the second substrate carrier head system. Thus, the pad conditioner 540 is able to provide more consistent pad surface conditions to the substrates held by the first and second substrate carrier head systems. In contrast, a pad conditioner that does not sweep across the entire platen 512 would result in differing pad surface conditions experienced by the two substrates.

In another embodiment, the CMP controller may be further configured, in a system with at least two CMP carrier head systems, to control either carrier head system to replace a polishing pad (e.g., a consumable) of a first platen. In such embodiments, a second carrier head system may continue to process wafers on a second platen while the first platen is temporarily offline. For example, a polishing pad may be prepared or pre-conditioned off-line (i.e., remote from the CMP processing station). The controller may place the first carrier head system in an offline state (e.g., in a state where the first carrier head is not processing wafers, for example, in a maintenance or repair mode). The second carrier head system may continue in a processing state. Accordingly, the controller may command the first carrier head system to attach the pre-conditioned polishing pad to the system. In some embodiments, this attachment would require removing the carrier head such that the pre-conditioned polishing pad may be attached in its place. In other embodiments, a separate attachment may need to be installed in place of the carrier head such that the pre-conditioned polishing pad can attach to the separate attachment.

In some embodiments, the CMP system 500 may be configured to advantageously stagger the processing of multiple wafers on multiple platens. For example, CMP system may include a first carrier head system and a second carrier head system where each system has a first arm and a second arm. In addition, each arm has a carrier head attached at one end.

The first carrier head system may process a first wafer on a first platen with a first arm while the second carrier head system processes a second wafer on a second platen with a second arm. Once the first wafer is processed for a predetermined amount of time or to a predetermined percentage of total processing (e.g., 80% processed), the first arm can rotate to move the first wafer to the second platen for a second CMP process. In some embodiments, the first and second CMP processes are different. For example, the first process may be a bulk removal process whereas the second process may be a fine removal process, in which the bulk removal process removes more material from a wafer than the fine removal process. For example, in some embodiments, the bulk removal process removes 80%, and the fine removal process removes 20%, of the total material removed from the wafer for the overall process. In addition, the second wafer may continue to be processed at the second platen. Meanwhile, a third wafer can be loaded using the second arm of the first carrier head system and processed on the first platen once the first wafer has been removed, and the process can repeat itself for subsequent wafer processing.

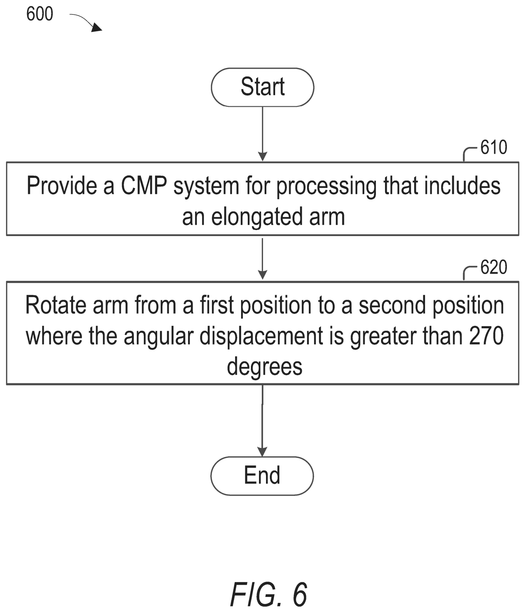

FIG. 6 is a flowchart illustrating an example method 600 for operating a CMP system in accordance with certain embodiments disclosed herein. In some aspects, method 600 may be performed by the system 100 of FIG. 1A to FIG. 1B. In some aspects, method 600 may be performed by the system 300 of FIG. 3A to FIG. 3B. In some aspects, method 600 may be performed by the system 400 of FIG. 4. In some aspects, method 600 may be performed by the system 500 of FIG. 5, or other systems.

In block 610, a CMP system is provided for processing a wafer. The CMP system includes an elongated arm rotatably attached to a support. In block 620, the arm is rotated from a first position to a second position. The rotation from the first position to the second position results in an angular displacement of more than 270°.

Thus, the present disclosure results in high throughput for processing a single wafer on a single platen by enabling concurrent processing of one wafer while loading and unloading of a sequential wafer, with both wafers being processed on the same platen sequentially. In addition, the present disclosure results in high throughput for processing two wafers on a single platen by enabling concurrently the processing of two wafers while loading and unloading of sequential wafers, with both wafers being processed on the same platen. Moreover, the disclosed technology is configured to result in a duty cycle of approximately 100% for the overall system. For example, the system may experience little to no down time with respect to processing wafers as a result of the configurations and embodiments described herein. Furthermore, the disclosed technology is configured to result in a reduced footprint for each CMP system (i.e., the support and arm(s)) and the overall system as a whole.

### Inverted Column Assemblies for CMP Systems

Embodiments of the CMP systems described in connection with FIG. 1A to FIG. 5 incorporate a vertical column assembly (for example, the supports 102, 302, 402, 404, and 502 of FIG. 1 and FIGS. 3 to 5) that can support two or more independent, articulated polish arms. The lower end of the column can include a mounting base for mechanically fastening the column to a horizontal deck plate that structurally supports the column. The column can extend through a plane of the platen(s) with the lower end of the column being coupled to the horizontal deck plate at a location below the plane of the platen(s).

One drawback to the use of a column supported from beneath the CMP system is that the column contributes to the overall area occupied by the CMP system. That is, since the platen(s) may have the largest area of the components within the CMP system, any component that occupies the same plane as the platen(s) will increase the area occupied by the CMP system.

Aspects of this disclosure improve on previous implementations by inverting the column assembly and mounting the column assembly to a supporting plate positioned above the polish deck. For example, the supporting plate can be mounted to the ceiling or a support structure otherwise located above the CMP system. Thus, a column assembly that is mounted to a supporting plate positioned above the CMP system is inverted compared to a CMP system having a column assembly mounted to a support located below the CMP system.

Inverting the column assembly of a CMP system allows the horizontal space (e.g., the area or footprint) occupied by the column to vertically overlap with the space occupied by other machine components such as the polish platen and conditioner assemblies. This arrangement substantially reduces the footprint of the CMP system relative to the other traditional CMP systems. Such footprint reduction in turn reduces the corresponding area required to operate the present CMP system in a semiconductor fabrication facility, thus reduces costs and overhead.

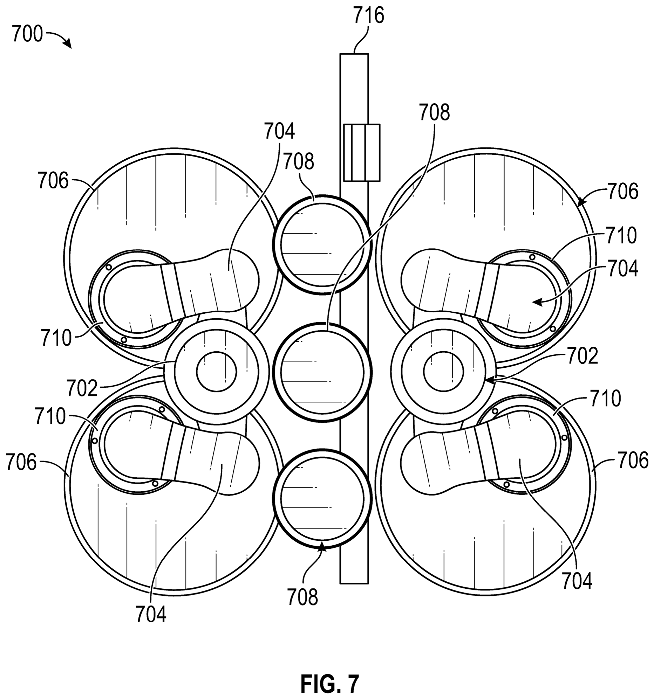

FIG. 7 illustrates an embodiment of a CMP system 700 having an inverted column assembly in accordance with aspects of this disclosure. In particular, FIG. 7 is a top view of a CMP system 700 including columns 702 (also referred to as a "support" or "support column"), polish arms 704, polish platens 706, transfer stations 708, and wafer carriers 710. In some embodiments, the CMP system 700 can also include a pad cooling system, a slurry delivery system, and/or a pad conditioner (such as the pad conditioner 540 of FIG. 5).

As in the embodiments of FIGS. 1A-5, the CMP system 700 is configured to polish a plurality of substrates on the polish platens 706. For example, the polish platens 706 are configured to polish at least one substrate held by one of the wafer carriers 710. The wafer carriers 710 can position the substrate above the polish platens 706 and apply pressure between the substrate and the polish platens 706 as the polish platens 706 spin to polish the substrate. This process may be substantially the same as the polishing process discussed in connection with 1 to FIG. 6.

As shown in FIG. 7, each of the columns 702 overlaps one or more of the polish platens 706. The columns 702 are arranged above the polish platens 706 such that the polish platens 706 can support the polish arms 704 and the wafer carriers 710 at a location above the polish platens 706. In this embodiment, the CMP system 700 includes two columns 702, four polish arms 704, and four platens 706. However, aspects of this disclosure are not limited thereto and the CMP system can include a greater or fewer number of columns 702, arms 704, and/or platens 706 without departing from aspects of this disclosure. With the configuration illustrated in FIG. 7, the CMP system 700 can process one wafer at a time on each of the four platens 706. In this case, the design of the conditioning arm 704 is not particularly limited since there is only one wafer/wafer carrier 710 on each platen 706.

In some embodiments, the CMP system 700 can also include a central wafer handling robot 716 configured to handle wafers within the CMP system 700. For example, the central wafer handling robot 716 can include vacuum suction configured to lift wafers and move the wafers to/from the transfer stations 708. The transfer stations 708 can be configured to hold substrates before and after polishing of the substrates on the polish platens 706.

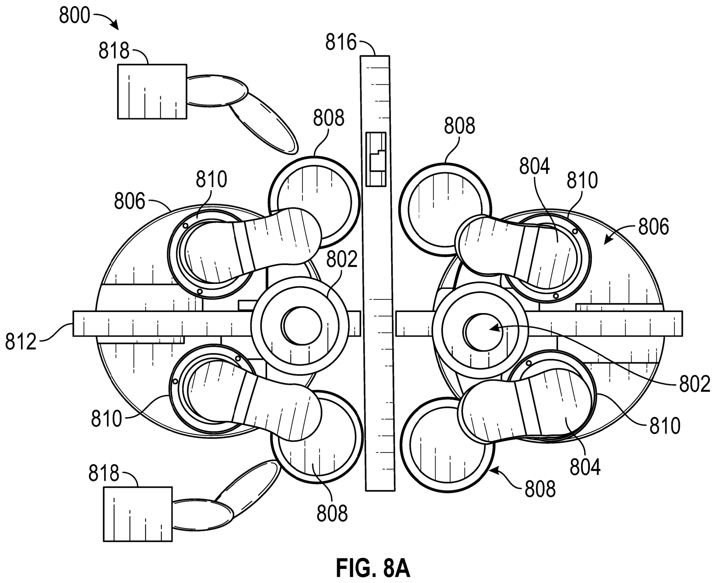

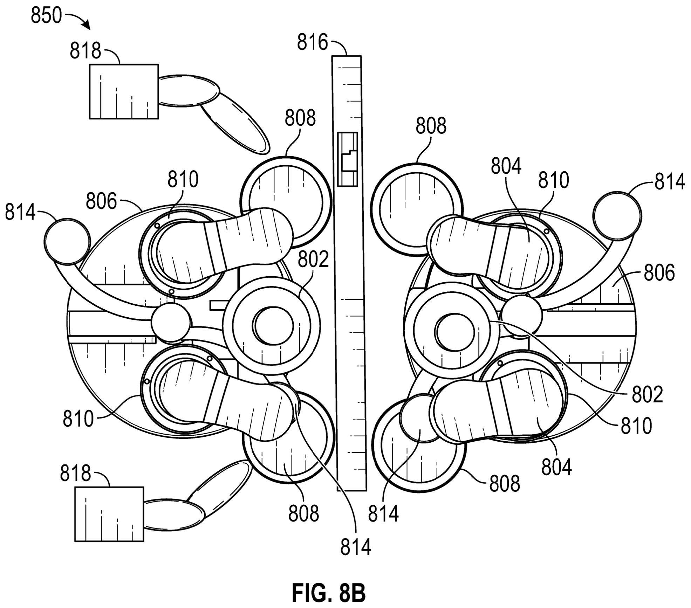

FIG. 8A and FIG. 8B illustrate embodiments of CMP systems having an inverted column assembly in accordance with aspects of this disclosure. Specifically, FIG. 8A illustrates a CMP system 800 using a pad conditioner that sweeps across the polish platens while FIG. 8B illustrates a CMP system 850 using arc sweep pad conditioners that each sweep across a portion of the polish platens.

The CMP system 800 includes columns 802, polish arms 804, polish platens 806, transfer stations 808, wafer carriers 810, and pad conditioners 812. In the illustrated embodiment, the CMP system 800 includes two columns 802, four polish arms 804, and two platens 806. Additionally, in this embodiment each of the columns 802 substantially completely overlaps a corresponding polish platen 806.

The CMP system 800 of FIG. 8A can enable both single- and dual-wafer polishing modes. Thus, the CMP system 800 can be configured to simultaneously polish two substrates on different areas of one of the polish platen 806. Together, this enables the CMP system 800 to polish up to four substrates simultaneously using only two polish platen 806.

In some embodiments, the CMP system 800 can also include a pad conditioner 812 for each polish platen 806. The pad conditioner 812 may be similar to the pad conditioner 540 described in connection with FIG. 5. By including the pad conditioner 812, dual-mode polishing can be improved by using the pad conditioner 812 to sweep a single pad conditioning disk across the entire diameter of the corresponding polish platen 806.

Referring to FIG. 8B, the CMP system 850 includes two arc sweep pad conditioners 814 for each polish platen 806. The other components of the CMP system 850 may be substantially the same as the CMP system 800 of FIG. 8A. For each polish platen 806, one arc sweep pad conditioner 814 can be placed upstream of a first one of the wafer carriers 810, while a second arc sweep pad conditioner 814 can be placed upstream of a second one of the wafer carriers 810.

In the embodiments of FIG. 8A and FIG. 8B, each of the pad conditioners 812 or the arc sweep pad conditioners 814 can include a pad conditioning disk which may have an abrasive surface facing the platen 806. As shown in FIG. 8A, the pad conditioners 812 can form a track that is arranged across the platen 806 and the pad conditioning disk can travel along the track to sweep across the platen 806. The arc sweep pad conditioners 814 illustrated in FIG. 8B are arranged to sweep the pad conditioning disk along an arc formed between a center of the polish platen 806 and an edge of the polish platen 806.

Advantageously, the pad conditioners 812 or the arc sweep pad conditioners 814 can be configured to condition the platen 806 during the simultaneous processing of two substrates. This can reduce the differences in the surface conditions experienced by two substrates being processed by a single platen 806. For example, in certain embodiments, by sweeping the pad conditioner 812 across substantially the entire platen 806, the pad conditioner 812 can alternate between being located upstream of a first wafer carrier 810 and being located upstream of a second wafer carrier 810. Thus, the pad conditioner 812 is able to provide more consistent pad surface conditions to the substrates held by the wafer carriers 810. Similarly, because the arc sweep pad conditioners 814 are each positioned upstream of a corresponding wafer carriers 810, the arc sweep pad conditioners 814 are also able to provide more consistent pad surface conditions to the substrates held by the wafer carriers 810. In contrast, a pad conditioner that does not sweep across the entire platen 806 would result in differing pad surface conditions experienced by the two substrates.

In some embodiments, the CMP system 800 can also include a central wafer handling robot 816 configured to handle wafers within the CMP system 800. For example, the central wafer handling robot 816 can include vacuum suction configured to lift wafers and move the wafers to/from the transfer stations 808. In other embodiments, the CMP system 800 can include two or more wafer handling robots 818 configured to move the wafers to/from the transfer stations 808. In the illustrated embodiments, the CMP system 800 can include two wafer handling robots 818 arranged on opposite sides of the CMP system 800. Advantageously, including two or more wafer handling robots 818 can increase the throughput of the system.

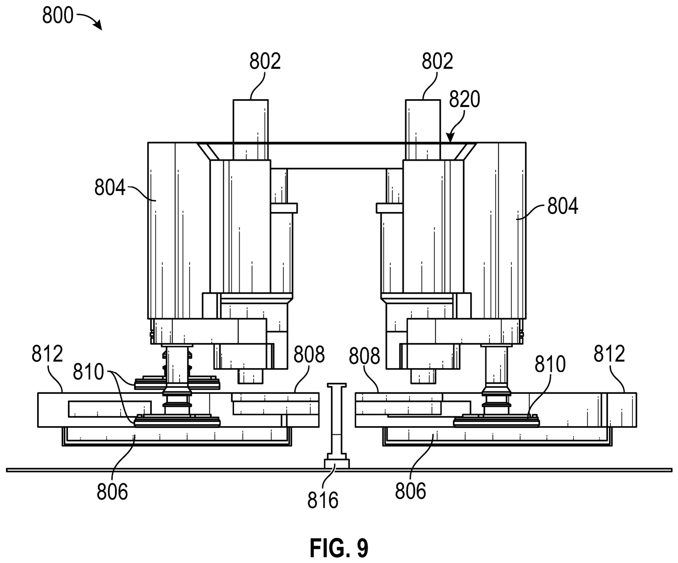

FIG. 9 provides a side view of a CMP system 800 having an inverted column assembly in accordance with aspects of this disclosure. The CMP system 800 of FIG. 9 may be substantially the same as the CMP system 800 of FIG. 8A.

In the embodiment of FIG. 9, the CMP system includes columns 802, polish arms 804, polish platens 806, transfer stations 808, wafer carriers 810, and pad conditioners 812. As shown in the side view of FIG. 9, the columns 802 do not extend through a plane in which the polish platens 806 are located. Thus, the columns 802 are located above the plane of the polish platens 806.

The CMP system 800 also includes a column support 820 configured to support both of the columns 802 from above. The column support 820 can be secured to a ceiling and/or a support structure located above the CMP system 800. Thus, the CMP system 800 includes columns in an inverted orientation which are structurally supported from above.

The column support 820 is configured to support the weight of each of the columns 802, the polish arms 804, and the wafer carriers 810. Thus, the column support 820 provides structural support for the polish arms 804 and the wafer carriers 810 via the columns 802. Although not illustrated in FIG. 7, FIG. 8A, and FIG. 8B, the CMP systems 700, 800, and 850 can each include a column support configured to support the columns 702 and the columns 802.

In some embodiments, one or more of the columns (e.g., columns 802) is rotatably coupled to the column support (e.g., column support 820) such that the column is configured to rotate about a substantially vertical axis relative to the column support. In such embodiments, rotation of the column may be used to align one or more of the polish arms with one or more platens, one or more transfer stations, and/or one or more maintenance positions. The column may be driven by a motor (e.g., a torque motor or servo motor) coupled to the column through a gearbox, belt drive, direct drive coupling, and/or other rotary transmission. The CMP system may include one or more bearings supporting the rotating column and one or more sensors (e.g., an absolute encoder) configured to provide rotational position feedback to a controller.

In some embodiments, the column support includes one or more internal routing passages, raceways, or channels configured to route electrical power, control signals, data communications, pneumatic pressure, vacuum, coolant, and/or process fluids between an overhead utility source and one or more columns. In some embodiments, one or more of such utilities is routed downward through an interior of a column and further through one or more arms to a wafer carrier. In embodiments including a rotatable column, the CMP system may include one or more rotary electrical couplings (e.g., slip rings) and/or rotary fluid couplings (e.g., rotary unions) to facilitate continuous or repeated rotation while maintaining electrical and/or fluid connectivity.

In some embodiments, the column is removably coupled to the column support to facilitate service and replacement. For example, the column may be mechanically coupled to the column support using one or more removable fasteners, kinematic mounts, clamps, bayonet-style couplings, and/or quick-release couplings. In some embodiments, the CMP system includes quick-disconnect utility couplings for one or more of electrical connections, data connections, pneumatics, vacuum, coolant, and/or process fluid lines so that the column and/or a column-mounted subassembly may be detached from the CMP system with reduced downtime.

In some embodiments, the CMP system includes vibration isolation between a facility structure and the column assembly. For example, vibration isolators may be provided between a ceiling or overhead facility frame and the column support, and/or between the column support and one or more columns. The vibration isolators may include elastomeric mounts, spring isolators, pneumatic isolators, viscous dampers, tuned mass dampers, and/or combinations thereof. In certain embodiments, the vibration isolation is configured to reduce transmission of facility vibration to one or more wafer carriers and/or to reduce transmission of vibration generated by one or more motors of the CMP system to a facility structure.

In some embodiments, the column support comprises an overhead frame or gantry configured to support a plurality of columns and/or a plurality of CMP modules. In some embodiments, the overhead frame includes standardized mounting interfaces such that columns may be installed, relocated, or replaced. In some embodiments, the overhead frame further includes one or more shared utility manifolds, distribution blocks, and/or routing channels configured to distribute one or more of power, data, pneumatic pressure, vacuum, coolant, and/or process fluids to the plurality of columns.

In some embodiments, the CMP system includes one or more sensors disposed in an arm, an arm joint, a column, and/or a wafer carrier, and a controller configured to operate the CMP system based at least in part on sensor output. By way of example, the sensors may include one or more torque sensors, strain gauges, accelerometers, vibration sensors, pressure sensors, temperature sensors, and/or acoustic emission sensors. In some embodiments, the controller is configured to use sensor outputs to control one or more of downforce applied to a substrate, carrier head motion, arm motion, platen speed, slurry flow, pad conditioning parameters, vibration suppression, and/or endpoint detection.

In some embodiments, one or more platens includes integrated subsystems configured to support polishing in a reduced-footprint architecture. For example, a platen may include one or more integrated coolant channels, fluid passages, and/or thermal control elements configured to cool a polishing pad, and one or more slurry dispense components configured to dispense slurry to the polishing pad. In some embodiments, one or more sensors are disposed in or on the platen and/or a polishing pad, including temperature sensors, acoustic sensors, optical sensors, impedance sensors, and/or eddy-current sensors, and the controller is configured to control at least one CMP parameter based on output of the sensors.

In some embodiments, the pad conditioner (including a full-sweep conditioner and/or an arc-sweep conditioner) is configured with a motion path selected to reduce interference with the overhead-suspended columns, the polish arms, and/or the wafer carriers. For example, a conditioner track, sweep radius, and/or stow position may be selected such that a conditioner disk clears a range of motion of one or more wafer carriers during single-wafer polishing, dual-wafer polishing, loading, unloading, and/or maintenance operations.

Aspects of this disclosure including the embodiments illustrated in FIG. 7-9 are able to decrease the overall footprint of a CMP system by providing an inverted column assembly in which the polish arms are supported by columns that are secured to support structures located above the CMP system, such that the columns do not overlap a plane occupied by the polish platens. This frees up space that would be otherwise occupied by the columns, enabling a CMP system that occupies a smaller area, which can improve spatial efficiency by allowing a greater number of CMP systems to be arranged within the same sized work area.

### Conclusion

Many variations and modifications may be made to the above-described embodiments, the elements of which are to be understood as being among other acceptable examples. All such modifications and variations are intended to be included herein within the scope of this disclosure. The foregoing description details certain embodiments. It will be appreciated, however, that no matter how detailed the foregoing appears in text, the systems and methods can be practiced in many ways and implemented in other forms. As is also stated above, it should be noted that the use of particular terminology when describing certain features or aspects of the systems and methods should not be taken to imply that the terminology is being re-defined herein to be restricted to including any specific characteristics of the features or aspects of the systems and methods with which that terminology is associated.

Conditional language, such as, among others, "can," "could," "might," or "may," unless specifically stated otherwise, or otherwise understood within the context as used, is generally intended to convey that certain embodiments include, while other embodiments do not include, certain features, elements, and/or steps. Thus, such conditional language is not generally intended to imply that features, elements and/or steps are in any way required for one or more embodiments or that one or more embodiments necessarily include logic for deciding, with or without user input or prompting, whether these features, elements and/or steps are included or are to be performed in any particular embodiment.

Conjunctive language such as the phrase "at least one of X, Y, and Z," or "at least one of X, Y, or Z," unless specifically stated otherwise, is to be understood with the context as used in general to convey that an item, term, etc. may be either X, Y, or Z, or a combination thereof. For example, the term "or" is used in its inclusive sense (and not in its exclusive sense) so that when used, for example, to connect a list of elements, the term "or" means one, some, or all of the elements in the list. Thus, such conjunctive language is not generally intended to imply that certain embodiments require at least one of X, at least one of Y, and at least one of Z to each be present.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

The term "a" as used herein should be given an inclusive rather than exclusive interpretation. For example, unless specifically noted, the term "a" should not be understood to mean "exactly one" or "one and only one"; instead, the term "a" means "one or more" or "at least one," whether used in the claims or elsewhere in the specification and regardless of uses of quantifiers such as "at least one," "one or more," or "a plurality" elsewhere in the claims or specification.

The term "comprising" as used herein should be given an inclusive rather than exclusive interpretation. For example, a general-purpose computer comprising one or more processors should not be interpreted as excluding other computer components, and may possibly include such components as memory, input/output devices, and/or network interfaces, among others.

While the above detailed description has shown, described, and pointed out novel features as applied to various embodiments, it may be understood that various omissions, substitutions, and changes in the form and details of the devices or processes illustrated may be made without departing from the spirit of the disclosure. As may be recognized, certain embodiments of the disclosed technology described herein may be embodied within a form that does not provide all of the features and benefits set forth herein, as some features may be used or practiced separately from others. The scope of certain aspects of the technology disclosed herein is indicated by the appended claims rather than by the foregoing description. All changes which come within the meaning and range of equivalency of the claims are to be embraced within their scope.

## Claims

1. A chemical mechanical planarization apparatus, comprising:
a column;
a first substrate carrier head system and a second substrate carrier head system, each of the first and second substrate carrier head systems comprising:
a polish arm connected to the column; and
a wafer carrier connected to the polish arm and configured to hold a substrate; and
a platen configured to polish at least one of a first substrate held by the first substrate carrier head system and a second substrate held by the second substrate carrier head system,
wherein the column overlaps at least a portion of the platen.

2. The apparatus of Claim 1, further comprising:
a column support arranged above the platen, wherein the column support is configured to support the column, the first substrate carrier head system, and the second substrate carrier head system.

3. The apparatus of Claim 1 or 2, wherein the platen is configured to simultaneously polish the first substrate and the second substrate on different areas of the platen.

4. The apparatus of Claim 3, wherein the column substantially completely overlaps the platen.

5. The apparatus of Claim 3 or 4, further comprising:
a pad conditioner configured to sweep across substantially the entire platen during the simultaneous polishing of the first substrate and the second substrate.

6. The apparatus of any one of Claims 3-5, further comprising:
a first arc sweep pad conditioner configured to sweep across a portion of the platen upstream of the first substrate carrier head system during the simultaneous polishing of the first substrate and the second substrate; and
a second arc sweep pad conditioner configured to sweep across a portion of the platen upstream of the second substrate carrier head system during the simultaneous polishing of the first substrate and the second substrate.

7. The apparatus of any one of Claims 1-6, further comprising:
a plurality of transfer stations configured to hold substrates before and after polishing of the substrates.

8. The apparatus of Claim 7, further comprising:
a central wafer handling robot configured to load and unload the substrates to and from the transfer stations.

9. The apparatus of Claim 7, further comprising:
a plurality of wafer handling robots configured to load and unload the substrates to and from the transfer stations.

10. A chemical mechanical planarization apparatus, comprising:
a column support;
a first column and a second column, the first and second columns structurally supported by the column support;
a first substrate carrier head system and a second substrate carrier head system, the first and second substrate carrier head systems structurally supported by the first column;
a third substrate carrier head system and a fourth substrate carrier head system, the third and fourth substrate carrier head systems structurally supported by the second column;
a first platen configured to polish at least one of a first substrate held by the first substrate carrier head system and a second substrate held by the second substrate carrier head system; and
a second platen configured to polish at least one of a third substrate held by the third substrate carrier head system and a fourth substrate held by the fourth substrate carrier head system,
wherein the first column overlaps at least a portion of the first platen and the second column overlaps at least a portion of the second platen.

11. The apparatus of Claim 10, wherein the first platen is configured to simultaneously polish the first substrate and the second substrate on different areas of the first platen, and the second platen is configured to simultaneously polish the third substrate and the fourth substrate on different areas of the second platen.

12. The apparatus of Claim 10 or 11, further comprising:
a third platen configured to polish the second substrate; and
a fourth platen configured to polish the fourth substrate,
wherein the first column overlaps the portion of the first platen and a portion of the third platen, and the second column overlaps the portion of the second platen and a portion of the fourth platen.

13. The apparatus of any one of Claims 10-12, wherein the first substrate carrier head system comprises:
a polish arm connected to the first column; and
a wafer carrier connected to the polish arm and configured to hold the first substrate.

14. The apparatus of any one of Claims 10-13, wherein the column support is arranged above the platens.

15. The apparatus of any one of Claims 10-14, wherein the first column is located above a plane of the first platen and the second column is located above a plane of the second platen.

16. The apparatus of any one of Claims 10-15, further comprising:
a plurality of transfer stations configured to hold the substrates before and after polishing of the substrates; and
a central wafer handling robot configured to load and unload the substrates to and from the transfer stations.

17. An inverted column assembly for a chemical mechanical planarization apparatus, comprising:
a column support; and
a first column and a second column, the first and second columns structurally supported by the column support, each of the first and second columns configured to support one or more substrate carrier head systems,
wherein the first column and the second column are located above a plane of one or more platens of the chemical mechanical planarization apparatus.

18. The inverted column assembly of Claim 17, wherein the column support is secured to a ceiling.

19. The inverted column assembly of Claim 17, wherein the column support is secured to a support structure located above the chemical mechanical planarization apparatus.

20. The inverted column assembly of any one of Claims 17-19, wherein the first column overlaps at least a portion of a first platen of the one or more platens and the second column overlaps at least a portion of a second platen of the one or more platens.
